# EUROPEAN PATENT APPLICATION

(11) **EP 1 071 121 A1**
(43) Date of publication of application: **24.01.2001**
(21) Application number: 00113999.7
(22) Date of filing: 01.07.2000
(51) Int. Cl.: H01L 21/3105, C09G 1/04, B24B 1/00

(54) **Process for the formation of a collar oxide in a trench in a semiconductor substrate**

(30) Priority: 19.07.1999 US 356157
(71) Applicant: International Business Machines Corporation, Armonk, NY 10504 (US); Infineon Technologies AG, 81541 München (DE)
(72) Inventor: Fairchok, Cynthia, Verbank, NY 12585 (US); Iba, Junihiro, Mohegan Lake, NY 10547 (US); Nützel, Joachim, Fishkill, NY 12524 (US); Yano, Hiroyuki, Isogo-Ku, 235-0022 (JP)
(74) Representative: Teufel, Fritz, Dipl.-Phys.

(57) **Abstract**

Polymeric layer is planarized by subjecting it to a chemical mechanical polishing step, selective to a dielectric layer also subjected to chemical mechanical polishing.

## Description

### FIELD OF THE INVENTION

The invention relates to a method for planarizing a layer of polymeric material such as photoresist during semiconductor device manufacturing processes.

### BACKGROUND OF THE INVENTION

Very large scale integrated circuit devices typically are manufactured on a substrate, such as a silicon wafer, by a sequence of material additions, such as low pressure chemical vapor depositions, sputtering operations, among others; material removals, such as wet etches, reactive ion etches, among others; and material modifications, such as oxidations, ion implants, among others. Typically, these physical and chemical operations interact with the entire substrate. For example, if a substrate is placed into an acid bath, the entire surface of the substrate will be etched away. In order to build very small electrically active devices on a substrate, the impact of these operations has to be confined to small, well-defined, regions.

Lithography in the context of VLSI manufacturing includes the process of patterning openings in photosensitive polymers, sometimes referred to as "photoresists" or "resists", which define small areas in which substrate material is modified by a specific operation in a sequence of processing steps.

The process of creating patterned openings in polymers is preferably carried out by radiation. Radiation causes desired photochemical reactions to occur within the photoresist. Preferably, the photochemical reactions alter the solubility characteristics of the photoresist, thereby allowing removal of certain portions of the photoresist. Photoresists can be negative photoresist or positive photoresist materials.

A negative photoresist material is one which is capable of polymerizing and being rendered insoluble upon exposure to radiation. Accordingly, when employing a negative photoresist material, the photoresist is selectively exposed to radiation, causing polymerization to occur above those regions of the substrate which are intended to be protected during a subsequent operation. The unexposed portions of the photoresist are removed by a solvent which is inert to the polymerized portion of the photoresist. Such a solvent may be an aqueous solvent solution.

Positive photoresist material is a material that, upon exposure to radiation, is capable of being rendered soluble in a solvent in which the unexposed resist is not soluble. Accordingly, when applying a positive photoresist material the photoresist is selectively exposed to radiation, causing the reaction to occur above those portions of the substrate which are not intended to be protected during the subsequent processing period. The exposed portions of the photoresist are removed by a solvent which is not capable of dissolving the exposed portion of the resist. Such a solvent may be an aqueous solvent solution.

Selectively removing certain parts of the photoresist allows for the protection of certain areas of the substrate while exposing other areas. The remaining portions of the photoresist may be used as a mask or stencil for processing the underlying substrate. For example, the openings in the mask may allow diffusion of desired impurities through the openings into the semiconductor substrate. Other processes are known for forming devices on a substrate.

The manufacturing of VLSI chips typically involves the repeated patterning of photoresists, followed by etch, implant, deposition, or other operation, and ending with the removal of the exposed photoresist to make way for the new photoresist to be applied for another iteration of this process sequence.

Often, to help ensure uniform processing of materials, the upper surface of a layer of a material deposited on a substrate may be processed to lie in substantially only one plane. Such processes are typically referred to as planarization.

Often, depositing a photoresist on a wafer such as by spinning does not achieve a homogenous thickness over the underlying substrate. Accordingly, the photoresist must be planarized. However, various techniques used for planarizing other materials have not been readily applicable to photoresists. One method currently used is referred to as "CDE". However, this process results in also reducing the thickness of other materials such as dielectric isolation (e.g. silicon nitride, silicon oxide, and silicon oxynitride) also present and exposed to the composition used. Accordingly, improved process for planarizing photoresists would be desirable.

### SUMMARY OF THE PRESENT INVENTION

Aspects of the present invention provide a method for planarizing a layer of polymer on a substrate. The method includes subjecting the layer of polymer to chemical mechanical polishing. The chemical mechanical polishing is highly selective to dielectric layer also subjected to the composition employed in the chemical mechanical polishing.

According to one particular aspect of the present invention, the dielectric layer is silicon nitride, silicon oxynitride and/or a silicon oxide wherein the silicon oxide is a silicate glass (doped or undoped), a high density plasma (HDP) oxide, a thermal oxide, and/or an oxide from silane, disilane, trimethylsilane, tetramethylsilane and/or hydrogen silsequioxane resin (commonly referred to as "flowable oxide").

A further particular aspect of the present invention relates to employing an abrasive-free polishing composition.

According to another particular aspect of the present invention, the polymer comprises a positive or negative photoresist which optionally can include a photoactive compound.

A further aspect of the present invention provides a method for forming a semiconductor device. The method includes forming at least one trench in a substrate. A layer of photoresist is deposited on the substrate and in the at least one trench. Deposition of photoresist in the at least one trench results in formation of recesses in an upper surface of the layer of photoresist. The layer of photoresist is subjected to chemical mechanical polishing which is selective to dielectric layer also subjected to the chemical mechanical polishing.

Still other objects and advantages of the present invention will become readily apparent by those skilled in the art from the following detailed description, wherein it is shown and described only the preferred embodiments of the invention, simply by way of illustration of the best mode contemplated of carrying out the invention. As will be realized, the invention is capable of other and different embodiments, and its several details are capable of modifications in various obvious respects, without departing from the invention. Accordingly, the drawings and description are to be regarded as illustrative in nature and not as restrictive.

### SUMMARY OF DRAWING

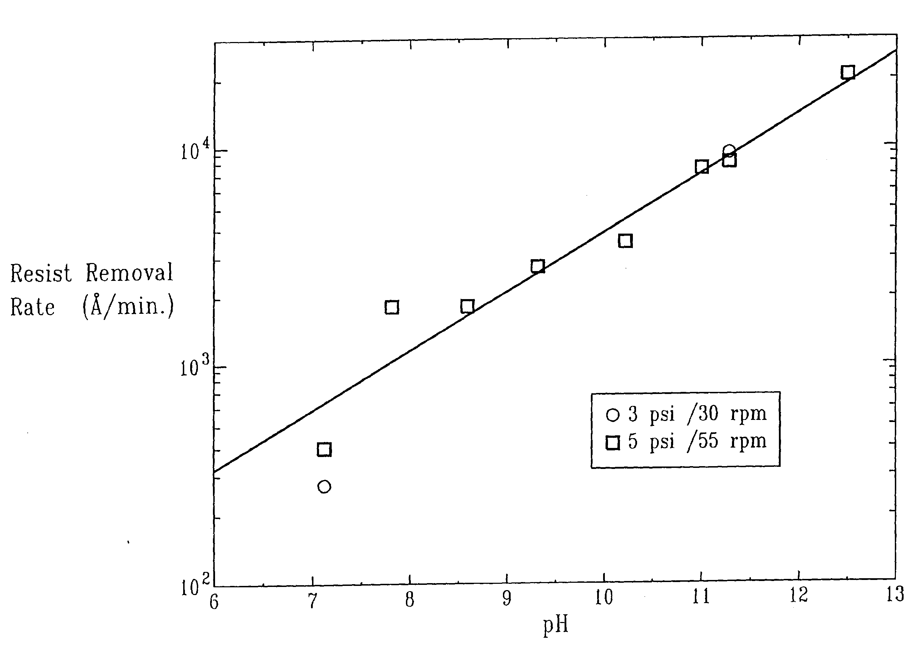

The figure is a graph illustrating the relationship between resist removal rate and pH.

### DESCRIPTION OF BEST AND VARIOUS MODES FOR CARRYING OUT THE INVENTION

During the process of forming semiconductor devices, often, portions of a substrate are removed to make a recess for certain purposes. For example, portions of the substrate may be removed to create a trench. According to one example, deep trenches are created in a substrate during the formation of DRAM devices.

After creation of a recess, such as a deep trench, the substrate, including the recess may be covered with a layer of photoresist. Due to the deposition of material in the recess, the top surface of the layer of photoresist may be depressed in an area in the vicinity of the trench, resulting in a recess being formed in the top surface of the layer of photoresist. This problem is particularly evident when coating substrates that include high aspect ratio trenches due to the high volume consumption of resist into the trenches.

Additionally, a typical layer of photoresist can typically be optimized to provide consistent resist thickness across the wafers on planar structures but not on top of trenches. The nonplanar profile of photoresist deposited over trenches and nonuniformity of the upper surface of a layer of photoresist across the wafers may translate down to resist recess depth and become a control problem for photoresist recess processes.

The present invention provides a method for planarizing photoresist prior to photoresist recess processes. The present invention method for planarizing a layer of photoresist may be particularly useful for defining three dimensional structures and high aspect ratio trenches for DRAM and DRAM derivatives as well as deep and shallow applications for logic and bipolar circuitries. Polycrystalline silicon recess processes may be applied when trenches are ready to be filled with a conducting material without requiring stripping of the polysilicon out of the trenches. However, with structures such as buried plates, vertical transistors, and collar oxide formation prior to node dielectric, trenches typically need to remain fully or partially empty after the intended processes. In these latter cases, polymer materials, such as photoresist, that can easily be stripped off without harming other portions of the structures maybe be required as recess materials.

Throughout this application, the term "resist recess" will be utilized to refer to processes carried out on a layer of photoresist utilizing stripable polymer materials. This is to be differentiated from depressions that may result in the upper layer of photoresist due to deposition of the photoresist in the trenches.

In addition, the present invention provides a method for planarizing polymeric materials including but not exclusive of photoresists. The photoresists employed according to the present invention include various known negative and positive photoresists and especially those used in semiconductor device manufacturing.

Among the polymers suitable for the present invention are polymers that contain phenolic hydroxy groups such as hydroxystyrene groups or novolak resins. These materials include copolymers thereof and include copolymers of hydroxystyrene and methacrylates and/or acrylates such as t-butyl methacrylate; poly (hydroxystyrene), poly(hydroxystyrene-co-t-butyloxycarbonyloxystyrene), poly(hydroxystyrene-co-hydroxymethyistyrene), poly(hydroxystyrene-co-acetoxymethyistyrene) alkyl substituted polyvinyl phenols and novolak resins such as cresol novolak, ethylphenol novolaks and xylenol novolaks.

Other suitable polymers are poly(p-tert-butoxycarbonyloxy-A-methyistyrene), poly(p-tert-butoxycarbonyloxystyrene), poly(tert-butyl p-vinylbenzoate), poly(tert-butyl p-isopropenylphenyloxyacetate), and poly(tert-butyl methacrylate).

In the case of photoresist compositions, photoactive compounds and photosensitizers can be used when desired.

When fabricating semiconductor device, a photoresist is typically deposited such as spinning onto a semiconductor substrate such as silicon, SOI (silicon on insulator), or silicon carbide. The structure typically also includes dielectric insulator such as silicon nitride, silicon oxide and/or silicon oxynitride. The silicon oxide employed in the processes of the present invention is typically obtained from silane, disilane, trimethylsilane, tetramethylsilane, hydrogen silsequioxane, a thermal oxide, doped and undoped silicate glass and/or a high density plasma (HDP) oxide. The dopants for the doped silicate glass are typically phosphorus, and/or boron, and/or fluorine. The preferred dielectric insulators are silicon nitride, doped silicate glass and HDP oxide.

According to the present invention, the polymer is planarized by chemical mechanical polishing. The polishing compositions employed according to the present invention are highly selective to dielectric layers and especially silicon nitride such as at least about 1:10, more typically at least about 1:100 and preferably at least about 1:1000. Accordingly, the polishing stops on the dielectric. In fact, overpolish results in at most only a small reduction of any underlying nitride and no significant recess in any trenches in the structure.

The composition typically has a pH of at least about 8, more typically at least about 10, and preferably about 11 to about 13.

Typical polishing compositions can contain an abrasive material such as silica or alumina in a basic solution. The polishing compositions typically also include an oxidizing agent such as oxidizing metal salts, oxidizing metal complexes, iron salts such as nitrates, sulfates, EDTA, citrates, potassium ferricyanide and the like, aluminum salts, sodium salts, potassium salts, ammonium salts, quaternary ammonium salts, phosphonium salts, peroxides, chlorates, perchlorates, permanganates, persulfates and mixtures thereof. Typically the oxidizing component is present in the slurry in amounts of up to about 2% wt. It has been found according to the present invention that the polishing composition can contain a strong base and does not require an oxidizing agent or an abrasive material. Suitable strong bases include hydroxides such as trimethylammonium hydroxide, sodium hydroxide, potassium hydroxide and ammonium hydroxide.

In order to further stabilize a polishing slurry containing an oxidizing component against settling, flocculation and decomposition of the oxidizing component, a variety of additives, such as surfactants, polymeric stabilizers or other surface active dispersing agents, can be used. Many examples of suitable surfactants for use in the present invention are disclosed in, for example, Kirk-Othmer, *Encyclopedia of Chemical Technology*, 3rd Edition, Vol. 22 (John Wiley & Sons, 1983), Sislet & Wood, *Encyclopedia of Surface Active Agents*, (Chemical Publishing Co., Inc., 1964) and available manufacturing literature, including for example McCutcheon's *Emulsifiers & Detergents, North American and International Edition* (McCutcheon Division, The MC Publishing Co., 1991), Ash, *The Condensed Encyclopedia of Surfactants* (Chemical Publishing Co., Inc., 1989), Ash, *What Every Chemical Technologist Wants to Know About . . . Emulsifiers and Wetting Agents, Volume I* (Chemical Publishing Co., Inc., 1988), Napper, *Polymeric Stabilization of Colloidal Dispersion* (Academic Press, 1983), and Rosen*, Surfactants & Interfacial Phenomena*, 2nd edition (John Wiley & Sons, 1989), all of which are incorporated herein by reference.

The preferred polishing compositions comprise up to about 30% of an abrasive such as silica and about 3e-5 to about 3e-2 of a strong base such as trimethylammonium hydroxide (TMAH). The preferred polishing slurries are aqueous compositions of TMAH without any abrasive, stabilizer or further oxidant. The water is preferably deionized water.

The planarizing comprises a circular motion of a wafer under a controlled downward pressure with a polishing pad saturated with the polishing composition.

Typically, the pressure is about 2 to about 10 psi, a typical example being about 5 psi down force, and the rotation speed of the polishing pad is about 20 to about 100 rpm, a typical example being about 55 rpm.

As illustrated in the figure, the removal rate increases as the pH increases. The polishing composition employed was a deionized water/TMAH composition.

The foregoing description of the invention illustrates and describes the present invention. Additionally, the disclosure shows and describes only the preferred embodiments of the invention but, as mentioned above, it is to be understood that the invention is capable of use in various other combinations, modifications, and environments and is capable of changes or modifications within the scope of the inventive concept as expressed herein, commensurate with the above teachings and/or the skill or knowledge of the relevant art. The embodiments described hereinabove are further intended to explain best modes known of practicing the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments.

## Claims

1. A method for planarizing a layer of polymer which comprises subjecting the polymer to chemical mechanical polishing which is selective to dielectric layer also subjected to the chemical mechanical polishing, wherein the dielectric layer is at least one member selected from the group consisting of silicon nitride, silicon oxynitride, silicate glass, thermal silicon oxide, high density plasma silicon oxide, oxide from at least one member selected from the group consisting of silane, disilane, trimethylsilane, tetramethylsilane and hydrogen silsequioxane resin.

2. The method of claim 1 wherein the dielectric layer is at least one member selected from the group consisting of silicon nitride, doped silicate glass and high density plasma silicon oxide.

3. The method of claim 1 wherein the dielectric layer comprises silicon nitride.

4. The method of claim 1 wherein the chemical mechanical polishing has a selectivity to the dielectric layer of at least about 10:1.

5. The method of claim 1 wherein the chemical mechanical polishing has a selectivity to the dielectric layer of about 100:1 to about 1000:1.

6. The method of claim 1 wherein the chemical mechanical polishing employs a polishing composition having a pH of at least about 8.

7. The method of claim 1 wherein the chemical mechanical polishing employs a polishing composition having a pH of at least about 10.

8. The method of claim 1 wherein the chemical mechanical polishing employs a polishing composition having a pH of about 11 to about 13.

9. The method of claim 6 wherein the polishing composition comprises trimethylammonium hydroxide.

10. The method of claim 1 wherein the polymer layer is about 0.5 to about 3 µm thick.

11. The method of claim 1 wherein the chemical mechanical polishing is carried out at a pressure of about 2 to about 10 psi and rotation speed of the polishing pad is about 20 to about 100 rpm.

12. The method of claim 1 wherein the layer of polymer comprises a positive or negative photoresist which optionally includes a photoactive compound.

13. The method of claim 12 wherein the polishing composition is an abrasive-free polishing composition.

14. The method of claim 9 wherein the polishing composition is an abrasive-free polishing composition.

15. The method of claim 1 wherein the polishing composition is an abrasive-free polishing composition.

16. A method for planarizing a layer of polymer which comprises: subjecting the polymer to chemical mechanical polishing which is selective to dielectric layer also subjected to the chemical mechanical polishing employing an abrasive-free polishing composition.

17. The method of claim 16 wherein the dielectric layer is at least one member selected from the group consisting of silicon nitride, doped silicate glass and high density plasma oxide.

18. The method of claim 16 wherein the dielectric layer comprises silicon nitride.

19. The method of claim 16 wherein the chemical mechanical polishing has a selectivity to the dielectric layer of at least about 10:1.

20. The method of claim 16 wherein the chemical mechanical polishing has a selectivity to the dielectric layer of about 100:1 to about 1000:1.

21. The method of claim 16 wherein the chemical mechanical polishing employs a polishing composition having a pH of at least about 8.

22. The method of claim 16 wherein the chemical mechanical polishing employs a polishing composition having a pH of at least about 10.

23. The method of claim 16 wherein the chemical mechanical polishing employs a polishing composition having a pH of about 11 to about 13.

24. The method of claim 21 wherein the polishing composition comprises trimethylammonium hydroxide.

25. The method of claim 16 wherein the polymer layer is about 0.5 to about 3 µm thick.

26. The method of claim 16 wherein the chemical mechanical polishing is carried out at a pressure of about 2 to about 10 psi and rotation speed of the polishing pad is about 20 to about 100 rpm.

27. The method of claim 16 wherein the layer of polymer comprises a positive or negative photoresist which optionally includes a photoactive compound.

28. A method for planarizing a layer of photoresist which comprises subjecting the photoresist to chemical mechanical polishing which is selective to dielectric layer also subjected to the chemical mechanical polishing.

29. The method of claim 28 wherein the dielectric layer is at least one member selected from the group consisting of silicon nitride, doped silicate glass and high density plasma oxide.

30. The method of claim 28 wherein the dielectric layer comprises silicon nitride.

31. The method of claim 28 wherein the chemical mechanical polishing has a selectivity to the dielectric layer of at least about 10:1.

32. The method of claim 28 wherein the chemical mechanical polishing has a selectivity to the dielectric layer of about 100:1 to about 1000:1.

33. The method of claim 28 wherein the chemical mechanical polishing employs a polishing composition having a pH of at least about 8.

34. The method of claim 28 wherein the chemical mechanical polishing employs a polishing composition having a pH of at least about 10.

35. The method of claim 28 wherein the chemical mechanical polishing employs a polishing composition having a pH of about 11 to about 13.

36. The method of claim 33 wherein the polishing composition comprises trimethylammonium hydroxide.

37. The method of claim 28 wherein the polymer layer is about 0.5 to about 3 µm thick.

38. The method of claim 28 wherein the chemical mechanical polishing is carried out at a pressure of about 2 to about 10 psi and rotation speed of the polishing pad is about 20 to about 100 rpm.

39. A method for fabricating a semiconductor structure which comprises:
forming at least one trench in a semiconductor substrate; depositing a layer of photoresist on the substrate and in the at least one trench; and
subjecting the layer of photoresist to chemical mechanical polishing which is selected to dielectric layer also subject to the chemical mechanical polishing.

40. The method of claim 39 wherein the dielectric layer is at least one member selected from the group consisting of silicon nitride, doped silicate glass and high density plasma oxide.

41. The method of claim 39 wherein the dielectric layer comprises silicon nitride.

42. The method of claim 39 wherein the chemical mechanical polishing has a selectivity to the dielectric layer of at least about 10:1.

43. The method of claim 39 wherein the chemical mechanical polishing has a selectivity to the dielectric layer of about 100:1 to about 1000:1.

44. The method of claim 39 wherein the chemical mechanical polishing employs a polishing composition having a pH of at least about 8.

45. The method of claim 44 wherein the chemical mechanical polishing employs a polishing composition having a pH of at least about 10.

46. The method of claim 39 wherein the chemical mechanical polishing employs a polishing composition having a pH of about 11 to about 13.

47. The method of claim 44 wherein the polishing composition comprises trimethylammonium hydroxide.

48. The method of claim 39 wherein the photoresist layer is about 0.5 to about 3 µm thick.

49. The method of claim 39 wherein the chemical mechanical polishing is carried out at a pressure of about 2 to about 10 psi and rotation speed of the polishing pad is about 20 to about 100 rpm.
